Europäisches Patentamt

European Patent Office

Office européen des brevets

(19)

(11) **EP 1 415 321 B1**

(12) **EUROPÄISCHE PATENTSCHRIFT**

(45) Veröffentlichungstag und Bekanntmachung des Hinweises auf die Patenterteilung:
**11.05.2005 Patentblatt 2005/19**

(21) Anmeldenummer: 02767344.1

(22) Anmeldetag: **07.08.2002**

(51) Int Cl.⁷: **H01J 37/32**

(86) Internationale Anmeldenummer:
**PCT/EP2002/008852**

(87) Internationale Veröffentlichungsnummer:
**WO 2003/015122 (20.02.2003 Gazette 2003/08)**

(54) **VORRICHTUNG ZUM BESCHICHTEN VON GEGENSTÄNDEN**

DEVICE FOR THE COATING OF OBJECTS

DISPOSITIF POUR MUNIR DES OBJETS D'UN REVETEMENT

(84) Benannte Vertragsstaaten:
**AT BE BG CH CY CZ DE DK EE ES FI FR GB GR IE IT LI LU MC NL PT SE SK TR**

(30) Priorität: **07.08.2001 DE 10138693**

(43) Veröffentlichungstag der Anmeldung:
**06.05.2004 Patentblatt 2004/19**

(73) Patentinhaber: **SCHOTT AG**
**55122 Mainz (DE)**

(72) Erfinder:
• **BEHLE, Stephan**
**55278 Hahnheim (DE)**
• **BEWIG, Lars**
**37581 Bad Gandersheim (DE)**
• **KÜPPER, Thomas**
**37581 Bad Gandersheim (DE)**
• **MARING, Wolfram**
**22337 Hamburg (DE)**
• **MÖLLE, Christoph**
**37581 Bad Gandersheim (DE)**
• **WALTHER, Marten**
**55270 Engelstadt (DE)**

(74) Vertreter: **Herden, Andreas, Dipl.-Ing.**
**Blumbach - Zinngrebe**
**Patentanwälte**
**Alexandrastrasse 5**
**65187 Wiesbaden (DE)**

(56) Entgegenhaltungen:
US-A- 5 053 678    US-A- 5 202 095
US-A- 5 874 706

• PATENT ABSTRACTS OF JAPAN vol. 011, no. 061 (E-483), 25. Februar 1987 (1987-02-25) & JP 61 220486 A (MITSUBISHI ELECTRIC CORP), 30. September 1986 (1986-09-30)
• PATENT ABSTRACTS OF JAPAN vol. 2000, no. 24, 11. Mai 2001 (2001-05-11) & JP 2001 192840 A (SHARP CORP;OMI TADAHIRO), 17. Juli 2001 (2001-07-17)
• PATENT ABSTRACTS OF JAPAN vol. 007, no. 185 (C-181), 13. August 1983 (1983-08-13) & JP 58 088086 A (SANKI KOGYO KK), 26. Mai 1983 (1983-05-26)
• YOSHIKAZU YOSHIDA: "PLASMA PROPERTIES IN THE OPEN-ENDED REGION OF A COAXIAL-TYPE MICROWAVE CAVITY" REVIEW OF SCIENTIFIC INSTRUMENTS, AMERICAN INSTITUTE OF PHYSICS. NEW YORK, US, Bd. 62, Nr. 6, 1. Juni 1991 (1991-06-01), Seiten 1498-1503, XP000235636 ISSN: 0034-6748

**Beschreibung**

Die Erfindung betrifft eine Vorrichtung zum Beschichten von Gegenständen mittels Bedampfung. Dabei sind Beschichtungs-Prozeßkammern an eine Mikrowelleneinrichtung angeschlossen.

Als Gegenstände kommen beispielsweise optische Gegenstände in Betracht, wie etwa Reflektoren als Bestandteil von Lampen, aber auch Fläschchen zur Verwendung durch die pharmazeutische oder chemische Industrie. Dies sind jedoch nur Beispiele aus einer Vielzahl praktischer Anwendungsfälle.

Aus der DE 689 26 923 T2 ist eine Mikrowellen-Ionenquelle bekannt, bei welcher Plasmakammern mit mehreren Koaxialleitungen mit einer Koaxialleitung eines Mikrowellengenerators verbunden sind. Die Plasmakammern stehen dabei kommunizierend miteinander in Verbindung, so daß sich die elektromagnetischen Felder in den einzelnen Kammern gegenseitig beeinflussen. Aus jeder Plasmakammer der Mikrowellen-Ionenquelle tritt ein Ionenstrahl aus, wobei durch das Zusammenwirken der Plasmakammern ein großflächiger Ionenstrahl erzeugt wird.

DE 195 03 205 C1 betrifft eine Vorrichtung zum Erzeugen von Plasma in einem Unterdruckbehälter mit Hilfe elektromagnetischer Wechselfelder, wobei ein stabförmiger Leiter innerhalb eines Rohres aus isolierendem Werkstoff durch den Unterdruckbehälter geführt ist.

DE 41 36 297 A1 beschreibt eine Vorrichtung zum lokalen Erzeugen von Plasma mittels Mikrowellen-Anregung. Dabei ist in einer Behandlungskammer ein Rohr aus isolierendem Material vorgesehen, das als Begrenzung zum Unterdruckbereich hin wirkt und in dem ein Innenleiter aus Metall verläuft; in den Innenleiter werden die Mikrowellen von einer Mikrowellenquelle eingekoppelt. Diese bekannte Vorrichtung nutzt den Effekt aus, daß durch die Fähigkeit des ionisierten Gases an der Außenwand des Führungshohlleiters eine Art Koaxialleitung entsteht, die die Mikrowelle weiterleitet.

An solche Vorrichtungen werden zahlreiche Anforderungen gestellt. Das Beschichtungsergebnis muß den Erfordernissen entsprechen, beispielsweise bezüglich der Gleichmäßigkeit der Schichtdicke sowie der Reproduzierbarkeit von Gegenstand zu Gegenstand. Ferner soll die Anlage einen möglichst hohen Ausstoß an Gegenständen pro Zeiteinheit haben. Der Energieverbrauch soll möglichst gering sein.

Diese Anforderungen werden von den bekannten Vorrichtungen nicht oder nicht vollständig erfüllt.

Der Erfindung liegt die Aufgabe zugrunde, eine Vorrichtung der eingangs genannten Art, umfassend eine Mikrowellenquelle sowie Beschichtungskammern, derart zu gestalten, daß bei einem bestimmten Investitionsaufwand eine höhere Produktionsleistung als bisher erzielt werden kann, daß der Energieaufwand geringer als bei bekannten Vorrichtungen ist, und daß eine Raumeinsparung erzielt wird.

Diese Aufgabe wird durch die Merkmale von Anspruch 1 gelöst.

Demgemäß besteht der Grundgedanke der Erfindung darin, eine einzige Mikrowellenquelle vorzusehen, um zwei oder mehrere Beschichtungskammern zu versorgen, statt nur einer einzigen, so wie dies seither der Fall war. Der Grundgedanke besteht in einer Aufteilung und Einkopplung der Mikrowellenenergie zur Erzeugung des Plasmas für die Beschichtung in getrennten Kammern durch geeignete Impedanz- bzw. Hohlleiterstrukturen.

In einer ersten Ausführungsform der Erfindung ist vorgesehen, die Aufteilung der Mikrowellenenergie im Hohlleiter selbst vorzunehmen. Hierfür können geeignete Hohlleiterbauelemente wie zum Beispiel y-Divider verwandt werden. Die im Hohlleiterbauelement aufgeteilte Mikrowellenenergie wird dann in die jeweilige Beschichtungskammer, beispielsweise durch dielektrische Fenster oder koaxiale Leiterstrukturen, eingekoppelt. Denkbar ist jede Form von Hohlleiter, beispielsweise Rechteckhohlleiter oder Rundhohlleiter.
Eine andere Ausführungsform der Erfindung besteht darin, die Mikrowellenenergie in einer Impedanzstruktur, umfassend beispielsweise koaxiale Leiterstrukturen, aufzuteilen.

Besonders vorteilhaft wird dabei die Mikrowellenquelle für PICVD-Betrieb gepulst betrieben. Dies kann beispielsweise durch eine gepulste Energieversorgung geschehen. Jedoch ist auch beispielsweise eine ungepulste, zeitlich modulierte Mikrowellenquelle, beziehungsweis eine entsprechende Energieversorgung möglich. In beiden Fällen wird die Plasmaintensität moduliert. Dies ermöglicht einen Gasaustausch bei geringerer Plasmaintensität, insbesondere während der Pulspausen im PICVD-Betrieb und senkt die Wärmebelastung.

In einer besonders bevorzugten Ausführungsform wird die Energie der einzigen Mikrowellenquelle in die jeweilige Beschichtungskammer mittels einer koaxialen Leiterstruktur mit einem metallischen Innenleiter und einem Dielektrikum als Außenleiter eingekoppelt. Bei einer derartigen Einkopplung ist es besonders vorteilhaft, Mittel vorzusehen, um die elektrische Länge der einzelnen Koaxialleiter verändern zu können. Diese Maßnahme gestattet es, daß bei zwei oder mehreren Beschichtungskammern die Impedanz des einen Leiterzweiges derart beeinflußt werden kann, daß in beiden oder allen Leiterzweigen ein Plasma angezündet wird. Um dies zu erreichen, ist die Impedanz, beispielsweise durch Verändern der elektrischen Länge der einzelnen Koaxialleiter, so zu wählen, daß alle Beschichtungsplätze die gleiche Energieversorgung erhalten. Wechselzünden oder das Zünden eines Plasmas in einzelnen Kammern soll durch eine geeignete Impedanzwahl vermieden werden.

Die Beschichtungskammern sind dabei vorteilhaft getrennt zueinander angeordnet. Insbesondere sind die Kammern gegenseitig abgeschirmt, so daß sich die Plasmen in den Kammern und die elektromagnetischen Felder nicht gegenseitig beeinflussen können. Vorzugsweise ist in jeder der Beschichtungskammern jeweils ein zu beschichtender Gegenstand aufnehmbar oder es wird jeweils eine Beschichtungskammer (10, 10') von einem zu beschichtenden Gegenstand gebildet.

Bei Koaxialleitern können die Impedanzen dadurch verändert werden, daß die vom Dielektrikum umbegebene Länge der einzelnen Leiter geändert wird.

Weitere Ausgestaltungen der Erfindung ergeben sich aus den Unteransprüchen und der beiliegenden Beschreibung.

Die Erfindung ist anhand der Zeichnung näher erläutert. Darin ist im einzelnen folgendes dargestellt:

Figur 1: zeigt in einer schematischen Darstellung einen Ausschnitt einer PICVD-Beschichtungsanlage, bei der die Aufteilung der Mikrowellenenergie mittels einer Impedanzstruktur vorgenommen wird

Figur 2: zeigt detailliert eine Ausgestaltung gemäß Figur 1

Figur 3A zeigt in einer schematischen Darstellung einen Ausschnitt einer weiteren Ausführungsform einer PICVD-Beschichtungsanlage, bei welcher die Aufteilung der Mikrowellenenergie mittels einer Impedanzstruktur vorgenommen wird

Figur 3B zeigt detailliert eine Ausgestaltung der Ausführungsform gemäß Figur 1

Figur 3C zeigt in einer schematischen Darstellung einen Ausschnitt noch einer weiteren Ausführungsform einer PICVD-Beschichtungsanlage, bei welcher die Aufteilung der Mikrowellenenergie mittels einer Impedanzstruktur mit Hohlleitern vorgenommen wird

Figur 3D zeigt detailliert eine Ausgestaltung der Ausführungsform gemäß Figur 3C.

Figur 4A: Hohlleiter mit y-Divider zum Aufteilen der Mikrowellenenergie auf zwei Zweige

Figur 4B: Ansicht eines Rechteckhohlleiters mit Koaxialleiter zum Auskoppeln der Mikrowellenenergie in einzelne Beschichtungskammern

Figur 5: Ansicht eines Rechteckhohlleiters mit dielektrischen Fenstern zum Auskoppeln der Mikrowellenenergie in einzelne Beschichtungskammern

Figur 6: System von Koaxial- oder Hohlleitern zur Versorgung von mehr als zwei Beschichtungsplätzen

Figur 7: alternative Ausgestaltung eines Systems gemäß Figur 6.

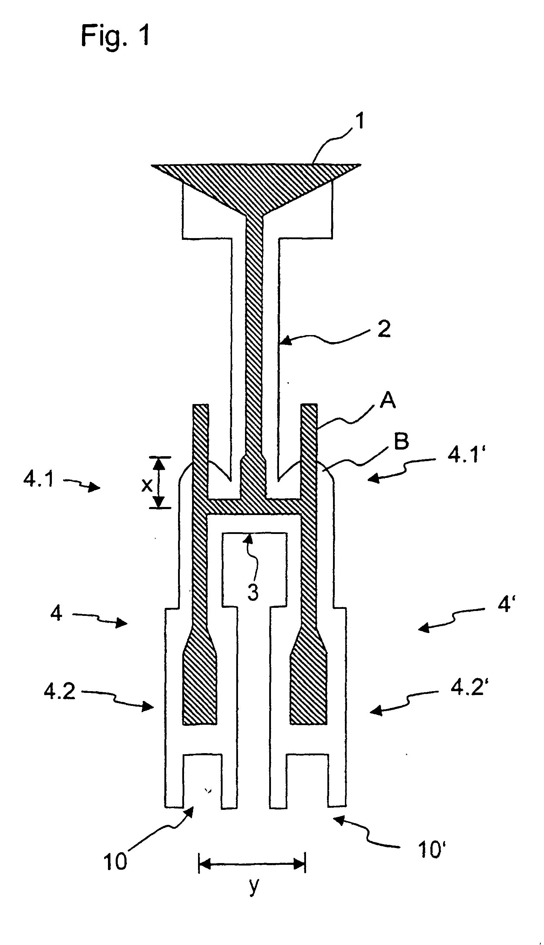

In Figur 1 ist eine erste Ausführungsform der Erfindung dargestellt, bei der eine Aufteilung der Mikrowellenenergie der einzigen Mikrowellenquelle im Impedanzzweig vorgenommen wird.

Bei der in Figur 1 dargestellten Vorrichtung erkennt man einen oberen Bereich, an den eine hier nicht dargestellte Mikrowellenquelle angeschlossen ist, während der untere Bereich die Beschichtungskammern umfaßt. Dabei umfaßt die Vorrichtung eine Koaxialstruktur, umfassend einen Innenleiter A und einen Außenleiter B. Der Innenleiter A besteht aus Metall, und der Außenleiter B ist ein Dielektrikum, im vorliegenden Falle ein Luftspalt. Das Dielektrikum ist begrenzt durch eine metallische Fläche. Als Dielektrikum wird im Sinne der Erfindung ein nichtmetallisches, beziehungsweise ein nicht metallisch leitendes Medium verstanden. Dementsprechend umfaßt ein Dielektrikum im hier verwendeten Sinne auch ein Medium, wie etwa Luft oder Vakuum.

Im vorliegenden Falle sind zwei Behandlungskammern 10, 10' vorgesehen, die von der einzigen Mikrowellenquelle versorgt werden. Dabei sind die Beschichtungskammern aus den Substraten selbst gebildet, beispielsweise aus Glasfläschchen, denen jeweils eine nicht dargestellte Gasdüse zugeordnet ist, oder es wird jeweils ein Substrat, etwa für eine Außenbeschichtung in eine der Kammern aufgenommen. Vorzugsweise sind die zu behandelnden Substrate dabei von gleicher Bauart. Statt Glasflaschen können auch Kunststofflaschen in Betracht kommen oder Reflektoren.

Der geometrische Aufbau der genannten koaxialen Leiterstruktur ist wie folgt gestaltet:

An die hier nicht näher dargestellte Mikrowellenquelle MwQ ist ein Kegel 1 angeschlossen. Dieser dient dem Herstellen eines Übergangs von einem hier nicht gezeigten Rechteck-Hohlleiter zu der genannten koaxialen Leiterstruktur.

An den Kegel 1 ist ein Leiter 2 angeschlossen. An den Leiter 2 schließt sich eine H-förmige Leiterstruktur an. Diese umfaßt einen Steg 3 sowie zwei Schenkel 4, 4'. Die beiden Schenkel sind wiederum zusammengefügt aus einem oberen Schenkelabschnitt 4.1 und einem unteren Schenkelabschnitt 4.2 beziehungsweise einem oberen Schenkelabschnitt 4.1' und einem unteren Schenkelabschnitt 4.2'.

Die Zuleitungen zu den Beschichtungskammern, beziehungsweise die Impedanzstruktur, insbesondere der Leiter 2 und die H-förmige Leiterstruktur sind als feste, beziehungsweise starre Leiter ausgeführt. Damit wird eine definierte Lage der Leiter erreicht, so daß die Leitung und Aufteilung der elektromagnetischen Energie nicht durch Bewegung der Leiter beeinflußt werden kann.

Wichtig ist das Maß x, auf das noch weiter unten eingegangen werden soll. Dies bedeutet jenen Längenabschnitt des Schenkelabschnittes 4.1 beziehungsweise 4.1', welcher vom Dielektrikum B umgeben ist.

Ein weiteres wichtiges Maß ist der gegenseitige Abstand y der unteren Schenkelabschnitte 4.2, 4.2', das heißt deren Abstand im Bereich der Behandlungskammern 10, 10'.

Die Erfinder haben erkannt, daß sich durch geeignete Wahl der genannten Parameter x und y die Verhältnisse in den Prozeßkammern (Beschichtungskammern) einstellen lassen, so daß jegliche Qualitätsunterschiede von Kammer zu Kammer eliminiert und eine bei allen Substraten akzeptable Beschichtungsqualität erzielen läßt.

Durch das erfindungsgemäße System läßt sich somit ein Doppelbeschichtungsplatz oder ein Mehrfachbeschichtungsplatz schaffen, mit welchem der Produktionsausstoß stark vergrößert und die Herstellkosten stark minimiert werden können. Insbesondere die Energiekosten lassen sich hierdurch senken. Die Qualität der Beschichtung läßt sich optimieren.

Dabei muß betont werden, daß von den beiden genannten Parametern x und y gegebenenfalls auch nur ein einziger verändert werden muß, um eine Justierung vorzunehmen. Wichtig ist vor allem Parameter x.

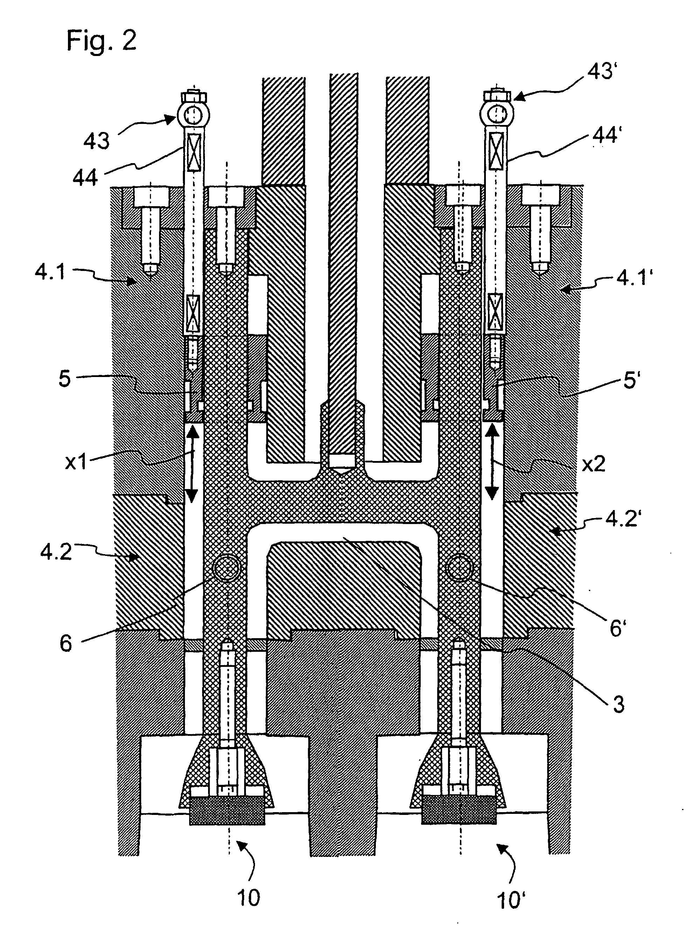

Figur 2 zeigt, wie dies praktisch verwirklicht werden kann. Man erkennt wiederum die koaxiale Leiterstruktur, zugleich auch die geometrische Struktur in Gestalt eines H.

Man erkennt ferner, daß die beiden Schenkelabschnitte 4.1, 4.1' jeweils von Hülsen 5, 5' umschlossen sind. Diese Hülsen sind entlang der Schenkelabschnitte verschiebbar. Damit läßt sich die elektrische Länge der Leiterstruktur verändern. Die Veränderung ist von Schenkelabschnitt zu Schenkelabschnitt unterschiedlich, so daß sich hiermit Einfluß nehmen läßt auf die Beschichtungsqualität der Beschichtungskammern 10, 10'. Die Verschiebung der Hülsen 5, 5' entlang der Schenkelabschnitte 4.1, beziehungsweise 4.1' erfolgt bei dieser Ausführungsform mittels einer Verstelleinrichtung 43, beziehungsweise 43', die jeweils eine mit den Hülsen 5, 5' verbundene Verstellschraube 44, beziehungsweise 44' umfaßt.

Aufgrund der Verstellung der Hülsen ergeben sich für beide Schenkel 4 und 4' bei unterschiedlicher Einstellung auch unterschiedliche Parameter x, die im folgenden als x1 und x2 bezeichnet werden. Für eine optimierte Einstellung der Vorrichtung werden sich die Werte der Parameter x1 und x2 jedoch im allgemeinen nur insoweit unterscheiden, als daß durch deren Unterschied kleine Unterschiede bei den Impedanzen der beiden Strecken der Impedanzstruktur ausgeglichen werden. Um einen einheitlichen Parameter x angeben zu können, kann daher mit guter Genauigkeit für x der Mittelwert der Parameter x1 und x2 angenommen werden,

$$x = \frac{1}{2}(x1 + x2).$$

Weiterhin läßt sich eine Beeinflussung dadurch vornehmen, daß in die Schenkel 4, 4' Schrauben 6, 6' mehr oder minder weit eingedreht werden, hier in die Schenkelabschnitte 4.2, 4.2'.

Wenn auch hier nicht dargestellt, so versteht es sich, daß auch dem Eingangsleiterabschnitt 2 eine Hülse zugeordnet werden kann, analog den beiden Hülsen 4.1, 4.1', oder eine Schraube, analog den beiden Schrauben 6, 6', oder beide dieser Mittel.

Für die hier beispielhaft dargestellte koaxiale Leiterstruktur gilt folgendes: Für gegebene Innenleiterdurchmesser erreicht man nur für ganz bestimmte Außenleiterdurchmesser und ganz bestimmte Verhältnisse der Parameter x zu y eine reflexionsfreie Anpassung.

Insbesondere zeigt sich, daß sich eine im wesentlichen reflexionsfreie Anpassung dann erreichen läßt, wenn der Parameter y ein Vielfaches der halben Wellenlänge der verwendeten elektromagnetischen Wellen ist, also, wenn im wesentlichen die Beziehung $y=n\lambda/2$, $n\in[1, 2, 3,...]$ erfüllt ist. Um befriedigende Ergebnisse für die Leistungsteilung in der Impedanzstruktur zu erreichen, sind somit den Abmessungen der Vorrichtung gewisse Einschränkungen gesetzt. Selbst bei einer Frequenz von 2,45 GHz beträgt die Wellenlänge in einem Koaxialleiter noch mehr als 12 cm, so dass der Abstand y bei Verwendung dieser Frequenz und Struktur nur als ganzzahliges Vielfaches von etwa 6 cm wählbar ist. Die Wellenlänge ist dabei außerdem abhängig davon, ob ein Koaxialleiter oder ein Hohlleiter verwendet wird. Beim Koaxialleiter ist die Wellenlänge nahe an der Vakuumwellenlänge. Bei einer R26-Hohlleiterstruktur beträgt die Wellenlänge bei 2,45 GHz beispielsweise etwa 17,4 cm, so dass y für diesen Fall für eine optimale Einstellung bei etwa 8,7cm liegt.

Manchmal werden bei der CVD-Technik auch noch niedrigere Frequenzen gewählt, so daß die entsprechenden Wellenlängen noch größer werden. Ebenso wird bei der PICVD-Technik für bestimmte Anwendungen, wie beispielsweise für großflächige Beschichtungen, eine niedrigere Frequenz verwendet, um besonders gleichmäßige Beschichungen zu erzielen. Dementsprechend steigen mit größerer Wellenlänge auch die damit verbundenen konstruktiven Einschränkungen der Beschichtungsvorrichtung.

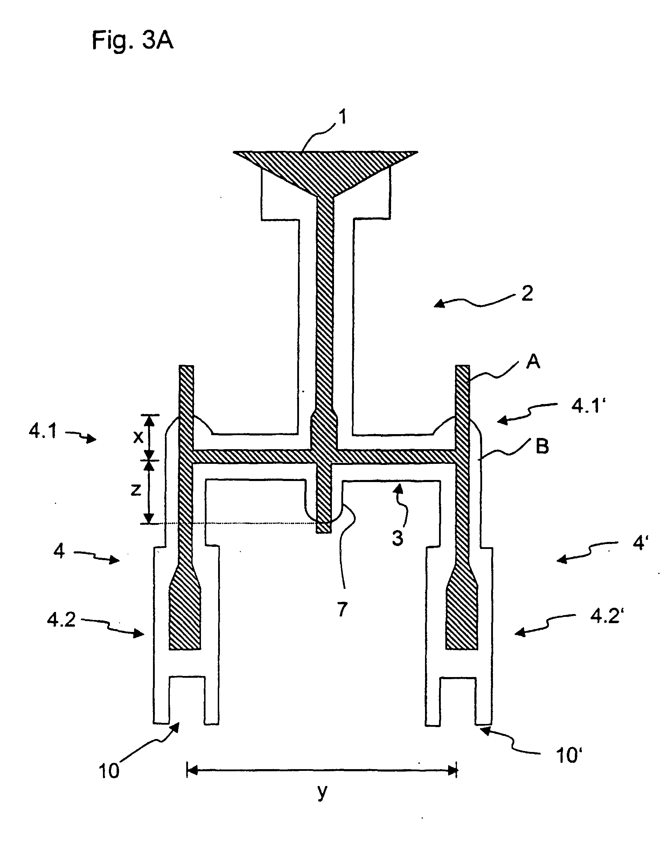

Es hat sich allerdings gezeigt, daß sich diese Einschränkungen vermeiden lassen, wenn die Impedanzstruktur einen weiteren Schenkel aufweist. Solche Ausführungsformen sind in den Figuren 3A bis 3D dargestellt. Bei den anhand der Figuren 3A bis 3D gezeigten Ausführungsformen wird, ähnlich wie bei der anhand der Figuren 1 und 2 erläuterten Ausführungsbeispielen eine Aufteilung der Mikrowellenenergie der einzigen Mikrowellenquelle im Impedanzzweig vorgenommen.

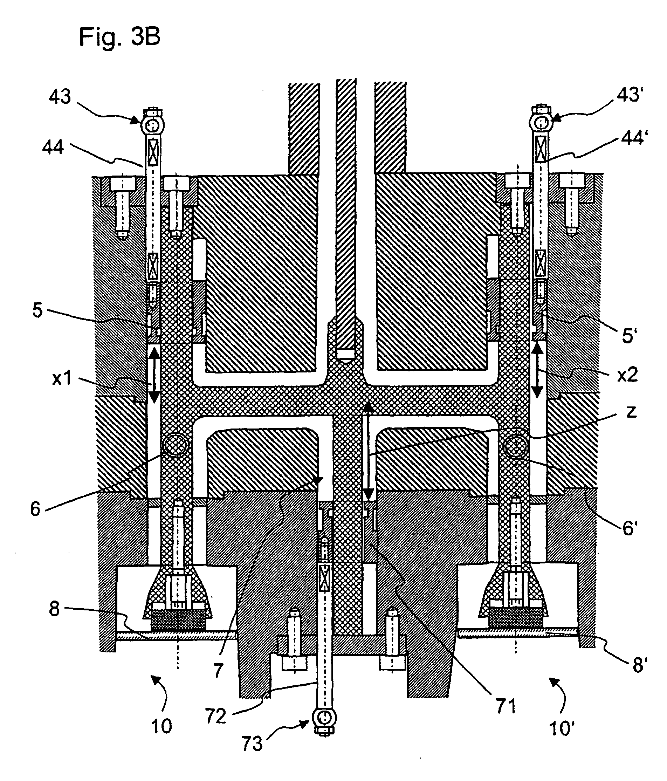

Die in den Figuren 3A und 3B dargestellte Vorrichtung umfaßt ebenfalls eine Koaxialstruktur mit einem Innenleiter A und einen Außenleiter B. Der Innenleiter A besteht vorzugsweise aus Metall, und der Außenleiter B ist ein durch eine leitende Fläche begrenztes Dielektrikum, beispielsweise ein Luftspalt.

Die durch die Impedanzstruktur aufgeteilte Mikrowellenenergie einer Mikrowellenquelle versorgt die Behandlungskammern 10 und 10'.

Ähnlich wie bei der oben beschriebenen Ausführungsform ist an den Leiter 2 eine H-förmige Leiterstruktur mit einem Steg 3 und zwei Schenkeln 4, 4' angeschlossen. Im Unterschied zu den oben beschriebenen Ausführungsformen weist die Impedanzstruktur einen weiteren Schenkel 7 auf, der mit dem Steg 3 verbunden ist.

Durch den Schenkel 7 wird ein Parameter z definiert, der durch die Länge des mit dem Dielektrikum B gefüllten Spalts, ausgehend von der Mitte des Stegs 3 ist. Der Schenkel setzt bei dieser Ausführungsform ebenso wie der Leiter 2 an der Mitte des Stegs 3 zwischen den beiden Schenkeln 4 und 4' an.

Der Schenkel 7 ist weiterhin bezüglich des Stegs 3 gegenüber dem Leiter 2 angeordnet, so daß Schenkel 7 und Leiter 2 in einer Linie liegen. Diese Anordnung ist jedoch nicht zwingend. Ebenso können Schenkel 7 und Leiter 2 sich entlang zweier Richtungen erstrecken, die in einem Winkel, etwa beispielsweise 90° zueinander liegen. Bei einer solchen Ausführungsform erstrecken sich dann Leiter 2, Steg 3 und Schenkel 7 entlang dreier im wesentlichen zueinander senkrechter Richtungen.

Figur 3B zeigt Details der in Figur 3A gezeigten Ausführungsform mit zusätzlichem Schenkel 7. Die koaxiale Leiterstruktur besitzt die geometrische Struktur in Gestalt eines H mit einem zusätzlichen Schenkel 7 an dessen Querbalken.

Die beiden Schenkelabschnitte 4.1, 4.1', sowie der Schenkel 7 sind jeweils von Hülsen 5, 5' und 71 umschlossen, die entlang der Schenkelabschnitte 4.1, 4.1', beziehungsweise des Schenkels 7 mittels Verstelleinrichtungen 43, 43', 73 verschiebbar sind. Die elektrische Länge der Schenkelabschnitte 4.1, 4.1' läßt sich wie bei der anhand der Figuren 1 und 2 gezeigten Ausführungsform mittels der Verstelleinrichtungen 43, beziehungsweise 43' unabhängig voneinander verändern. Bei dieser Ausführungsform ist auch eine Einstellung der elektrische Länge des Schenkels 7 mittels der Verstelleinrichtung 73 unabhängig von den anderen Einstellungen möglich. Dadurch können die Parameter x, x' und z einzeln eingestellt und eine gleichmäßige Aufteilung der Mikrowellenleistung erreicht werden.

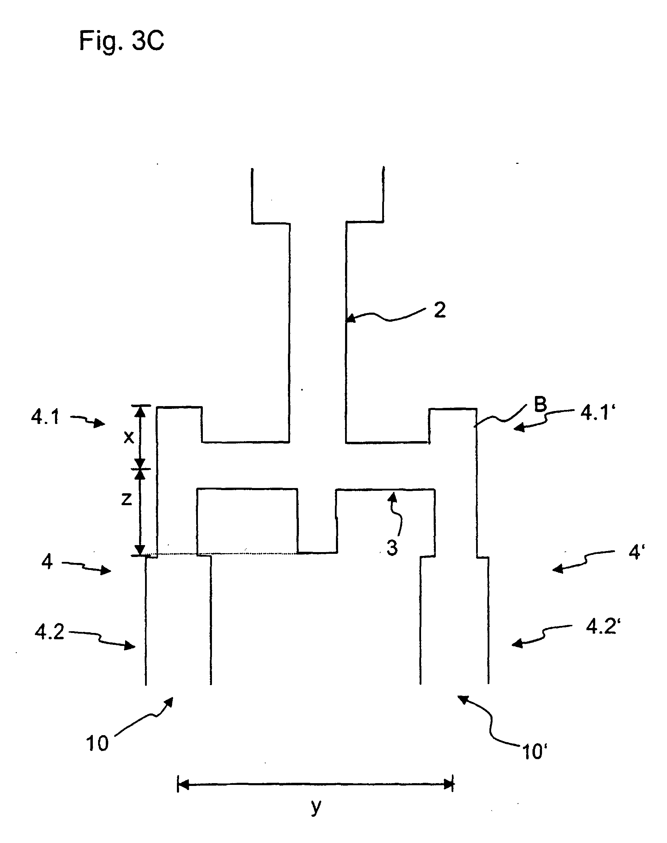

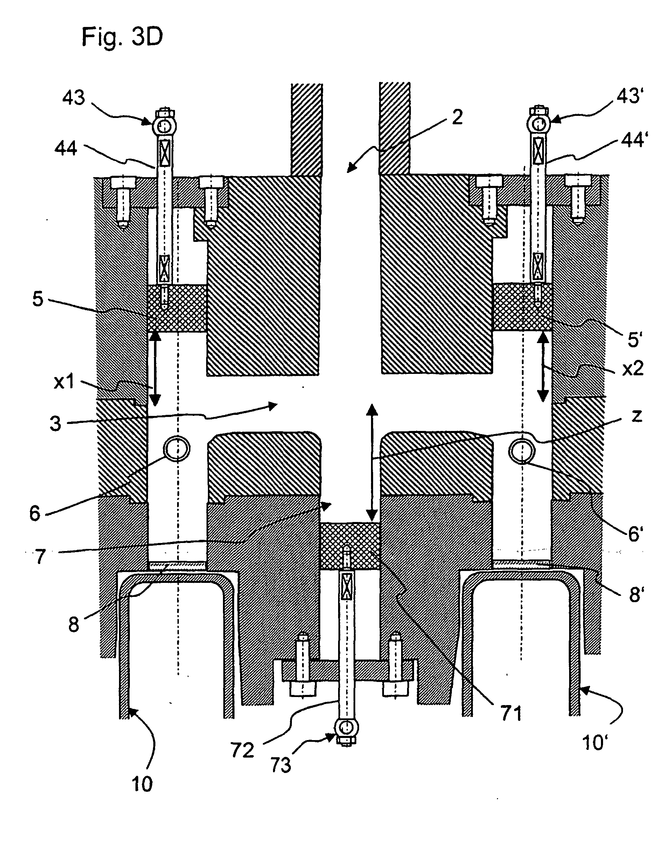

In den Figuren 3C und 3D ist eine Variante der anhand der Figuren 3A und 3b gezeigten Ausführungsform dargestellt. Bei dieser Variante umfaßt die Impedanzstruktur Hohlleiter anstelle der Koaxialleiter wie in den Figuren 3A und 3B. Die Hohlleiter können sowohl Rund-, als auch Rechteckhohlleiter umfassen. Eine solche Variante mit Hohlleitern ist insbesondere für höhere Frequenzen geeignet.

Auch bei dieser Variante können mittels entlang der Abschnitte 4.1, 4.1', beziehungsweise des Schenkels 7 verschiebbarer Hülsen 5, 5' und 71 die Parameter x1, x2 und z verstellt und optimiert werden.

Die Beschichtungskammern 10 und 10' können beispielsweise, wie in Fig. 3D dargestellt, von den zu beschichtenden Werkstücken gebildet werden. Dabei zeigt Figur 3D jeweils den Bodenbereich einer Ampulle, welcher mit der Leiterstruktur gekoppelt ist und durch welchen die Mikrowellen in das Innere der Ampulle gelangen. Neben Ampullen können auch andere hohlkörperförmige Werkstücke, wie beispielsweise Flaschen oder Kalotten, innen beschichtet werden oder es können andere Werkstücke, wie beispielsweise Lampenkolben, in getrennten Kammern außen beschichtet werden. Auch hier sind die Zuleitungen zu den Beschichtungskammern 10, 10', beziehungsweise die Impedanzstruktur, insbesondere der Leiter 2 und die H-förmige Leiterstruktur als feste oder starre Leiter ausgeführt.

Die Einkopplung der Mikrowellen in die Beschichtungskammern 10, 10' kann in allen Ausführungsformen auch, wie in den Figuren 3B und 3D dargestellt ist, über dielektrische Fenster 8, 8' erfolgen. Auf diese Weise wird das Zünden eines Plasmas in der Impedanzstruktur oder Hohlleiterstruktur vermieden, da das Eindringen von Prozeßgas vermieden wird oder ein Druck aufrechterhalten werden kann, bei welchem kein Plasma zündet.

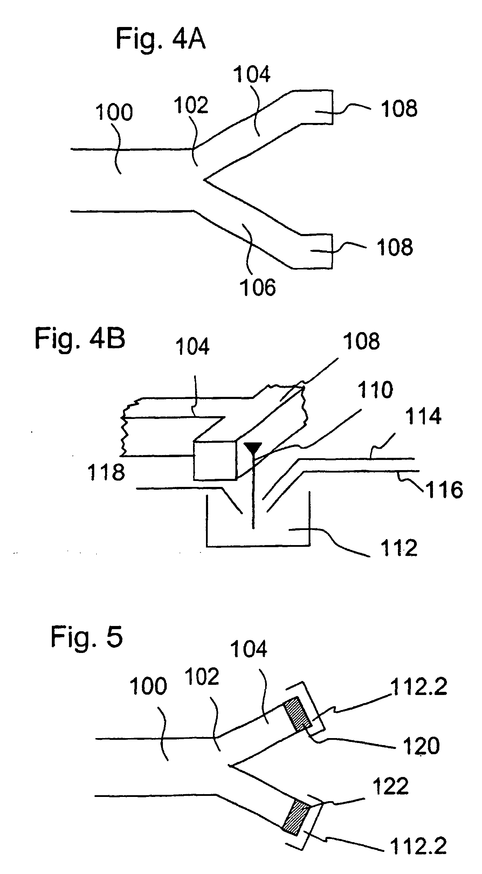

In den Figuren 4a und 4b sowie Figur 5 sind Ausführungsformen der Erfindung gezeigt, bei denen die Aufteilung der Mikrowellenenergie, die von einer nicht dargestellten Mikrowellenquelle erzeugt wird, bereits im Hohlleiter 100 vorgenommen wird. Die gesamte Mikrowellenenergie der Mikrowellenquelle wird in den Hohlleiter 100, beispielsweise ein Rechteckhohlleiter, eingekoppelt und im Bereich 102 in der dargestellten Ausführungsform in zwei Anteile aufgeteilt. Ein Teil der Mikrowellenenergie wird dem Rechteckhohlleiter 104 zugeführt, und ein Teil der Energie dem Rechteckhohlleiter 106. Die in die Zweige 104 bzw. 106 eingekoppelte Mikrowellenenergie wird zum Rechteckhohlleiter 108 transportiert. Im Rechteckhohlleiter 108 wird wie in Figur 4b dargestellt, die Mikrowellenenergie über Koaxialleiter 110 in die einzelnen Beschichtungskammern 112, die vorliegend die zu beschichtenden 3D-Behältnisse selbst sein können, eingekoppelt. Beispiele für 3D-Behältnisse, die mit vorliegendem Verfahren beschichtet werden können, sind Kalotten, Spritzen, Ampullen, Fläschchen, Katheter. Wichtig für die Erfindung ist, daß jedes 3D-Behältnis 112 eine eigenständige Vakuumversorgung 114 sowie eine eigenständige Gasversorgung 116 aufweist. Die eigenständigen Versorgungseinrichtungen erlauben es, die einzelnen Beschichtungskammern des Mehrplatz-Beschichtungssystems getrennt, d.h. einzeln, zu betreiben bzw. zu steuern.

Besonders vorteilhaft ist es, wenn die einzelnen Beschichtungskammern darüber hinaus über getrennte Plasma-Überwachungsvorrichtungen 118 zur Detektion von thermischer und/oder elektromagnetischer Emission, ausgehend vom Plasma oder dem zu beschichtenden Substrat, verfügen, so daß jede einzelne Beschichtungskammer einzeln gepulst betrieben werden kann.

Neben einer Einkopplung mittels von Koaxialleitern wie in Figur 4b gezeigt, ist es auch möglich, wie in Figur 5 dargestellt, die Energie der einzelnen Zweige 104 und 106 des aufgeteilten Hohlleiters mittels sogenannter dielektrischer Fenster (120,122) in die einzelnen Beschichtungskammern 112.1 und 112.2 einzukoppeln.

Kombinationen der dargestellten Ausführungsformen sind ebenfalls möglich.

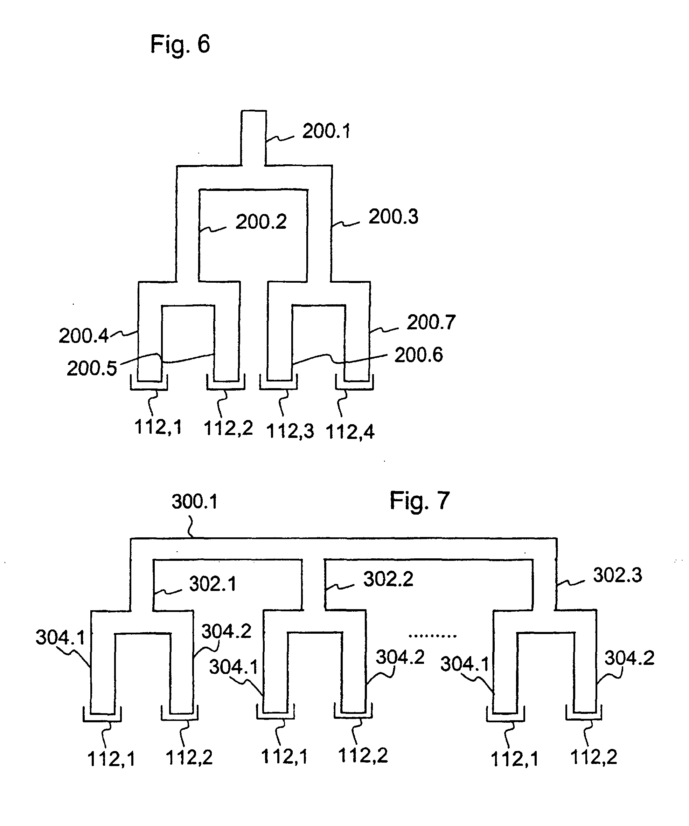

In den Figuren 6 und 7 sind Beispiele der Erfindung aufgezeigt, mit denen sich mehr als zwei Beschichtungsplätze realisieren lassen. Dies ist sowohl mit Hilfe von Koaxialleitern wie von Hohlleitern möglich.

Bei der Ausführungsform gemäß Figur 6 wird ein erster Koaxialleiter 200.1 in zwei Koaxialleiter 200.2, 200.3 gemäß der Erfindung aufgeteilt. Die Koaxialleiter 200.2, 200.3 wiederum werden in je zwei Koaxial- bzw. Hohlleiter 200.4, 200.5 sowie 200.6, 200.7 in Art einer Verzweigungskaskade aufgeteilt. Am Ende der Verzweigungskaskade befinden sich die einzelnen Beschichtungskammern 112.1, 112.2, 112.3, 112.4.

Alternativ zu einer kaskadenförmigen Ausgestaltung gemäß Figur 6 wäre auch denkbar, daß an einem gemeinsamen Hohlleiter 300.1 eine Vielzahl von Doppelplätzen 302.1, 302.2, 302.3 anschließen, die jeweils zwei Rechteckhohlleiter bzw. zwei Koaxialleiter 304.1, 304.2 umfassen. Unterhalb der jeweiligen Koaxial- bzw. Hohlleiter 304.1, 304.2 ist eine Beschichtungskammer 112.1, 112.2 angeordnet.

Mit der Erfindung wird erstmals eine Vorrichtung zum Beschichten von Gegenständen vorgestellt, mit der es möglich ist, mehrere Beschichtungskammern mit einer einzigen Mikrowellenquelle zu betreiben.

Durch die Erfindung können gepulste, aber auch nicht gepulste Mikrowellenenergien durch geschickte Aufteilung dazu benutzt werden, mehrere voneinander gentrennte Beschichtungsplätze mit Energie zu versorgen. Die Plätze bleiben aus beschichtungstechnischen Gründen, wie Vermeidung von Beeinflußung benachbarter Beschichtungsplätze, voneinander getrennt, werden aber mit einer Energiequelle versorgt. Durch die Erfindung kann sichergestellt werden, daß es nicht zu einem Wechselzünden, d.h. dem unkontrollierten Zünden der einem oder anderen Kammer kommt, sondern alle Kammern gleichzeitig zünden und über die Dauer der Beschichtung die gleiche Energieversorgung erhalten.

Es zeigt sich, daß sich die erfindungsgemäße Vorrichtung sehr unkritisch in bezug auf das Plasmavolumen, sowie auf die Gaszusammensetzung verhält. Mit der Vorrichtung konnten sowohl Innenbeschichtungen mit Plasmavolumen zwischen 2 und 10 ml zur Beschichtung von Ampullen, Innenbeschichtungen von Kalotten mit Plasmavolumen von etwa 50 ml, als auch Außenbeschichtungen von Glühbirnenkörpern mit Plasmavolumen bis zu 100 ml ohne Nachregelung der Prozeßparameter hergestellt werden. Dabei geht die Änderung des Plasmavolumens mit einer erheblichen Änderung der Impedanz einher. Darüber hinaus konnten für die verschiedenen Plasmavolumina auch verschiedene Gaszusammensetzungen, insbesondere auch mit unterschiedlichen Precursoren wie beispielsweise Hexamethyldisiloxan oder Titanchlorid jeweils mit unterschiedlichen Konzentrationen, ohne wesentliche Änderung der Plasmaeigenschaften und Beschichtungsqualität verwendet werden, wobei auch die Gaszusammensetzung die Impedanz erheblich beeinflußt.

**Patentansprüche**

1. Vorrichtung zum Beschichten von Gegenständen;
   mit einer einzigen Mikrowellenquelle;
   mit zwei oder mehreren getrennten Beschichtungskammern (10, 10');
   alle Beschichtungskammern (10, 10') sind an die einzige Mikrowellenquelle angeschlossen;
   es ist eine Impedanzstruktur oder eine Hohlleiterstruktur zur Aufteilung der Mikrowellenenergie zur Erzeugung getrennter Plasmen in den einzelnen Beschichtungskammern (10, 10') vorgesehen.

2. Vorrichtung nach Anspruch 1,
   **dadurch gekennzeichnet, daß** die Hohlleiterstruktur selbst wenigstens ein Bauteil zur Aufteilung der Mikrowellenenergie umfaßt.

3. Vorrichtung nach Anspruch 2,
   **dadurch gekennzeichnet, daß** das Bauteil zur Aufteilung der Mikrowellenenergie ein y-Divider ist.

4. Vorrichtung nach einem der Ansprüche 1 bis 3,
   **dadurch gekennzeichnet, daß** die Hohlleiterstruktur einen Rechteckhohlleiter umfaßt.

5. Vorrichtung nach einem der Ansprüche 1 bis 3,
   **dadurch gekennzeichnet, daß** die Hohlleiterstruktur Rundhohlleiter umfaßt.

6. Vorrichtung nach einem der Ansprüche 1 bis 5,
   **dadurch gekennzeichnet, daß** die Hohlleiterstruktur dielektrische Fenster (8, 8', 120, 122) oder koaxiale Leiterstrukturen (A, B, 110) zur Einkopplung der Mikrowellenenergie in die jeweilige Beschichtungskammer umfaßt.

7. Vorrichtung nach Anspruch 1,
   **dadurch gekennzeichnet, daß** die Impedanzstruktur selbst wenigstens ein Bauteil zur Aufteilung der Mikrowellenenergie umfaßt.

8. Vorrichtung nach Anspruch 7, **dadurch gekennzeichnet, daß** zur Einkopplung der Mikrowellenenergie in die einzelne Beschichtungskammer (10, 10') die Impedanzstruktur je eine koaxiale Leiterstruktur umfaßt, umfassend einen metallischen Innenleiter (A) und ein Dieleketrikum (B) als Außenleiter.

9. Vorrichtung gemäß Anspruch 8, **dadurch gekennzeichnet, daß** Mittel (5, 5'; 6, 6') vorgesehen sind, um die elektrische Länge der Innenleiter (A) zu verändern.

10. Vorrichtung nach Anspruch 8 oder 9, **dadurch gekennzeichnet, daß** die koaxiale Leiterstruktur einen ersten Leiterabschnitt (2) umfaßt, der eine Verbindung zwischen der Mikrowellenquelle und einer Verzweigungsstelle herstellt.

11. Vorrichtung nach einem der Ansprüche 1 bis 10, **gekennzeichnet durch** die folgenden Merkmale:

   mindestens zwei Behandlungskammern (10, 10') ist eine H-förmige Leiterstruktur vorgeschaltet, umfassend einen Steg (3) sowie zwei Schenkel (4, 4');
   der Steg (3) ist über einen Eingangsleiter (2) an die Mikrowellenquelle angeschlossen;
   jeder Schenkel (4, 4') der H-förmigen Leiterstruktur weist einen Abschnitt (4.1, 4.1') auf, der von der betreffenden Behandlungskammer (10, 10') abgewandt ist, sowie einen Abschnitt (4.2, 4.2'), der einer der Behandlungskammern (10, 10') zugewandt ist;

12. Vorrichtung nach Anspruch 11, wobei die elektrische Länge des von der betreffenden Behandlungskammer (10, 10') abgewandten Schenkelabschnittes einstellbar ist.

13. Vorrichtung nach Anspruch 12, **dadurch gekennzeichnet, daß** auch die elektrische Länge des Eingangsleiterabschnittes (2) einstellbar ist.

14. Vorrichtung nach Anspruch 12 oder 13, **dadurch gekennzeichnet, daß** die Mittel zum Einstellen der elektrischen Länge aus einer den inneren Leiter (A) umgebenden, verschiebbaren Hülse (5, 5') gebildet sind.

15. Vorrichtung nach einem der Ansprüche 11 bis 14, **dadurch gekennzeichnet, daß** die Mittel zum Einstellen der elektrischen Länge des Innenleiters (A) aus einer in den Innenleiter (A) eindrehbaren Schraube (6, 6') gebildet ist.

16. Vorrichtung nach einem der Ansprüche 11 bis 14, **dadurch gekennzeichnet, daß** der Steg (3) mit einem weiteren Schenkel (7) verbunden ist.

17. Vorrichtung nach Anspruch 16, **dadurch gekennzeichnet, daß** der weitere Schenkel (7) mit dem Steg (3) im wesentlichen in der Mitte des Stegs (3) zwischen den zwei Schenkeln (4, 4') verbunden ist.

18. Vorrichtung nach Anspruch 16 oder 17, **dadurch gekennzeichnet, daß** auch die elektrische Länge des weiteren Schenkels (7) einstellbar ist.

19. Vorrichtung nach einem der Ansprüche 11 bis 18, **dadurch gekennzeichnet, daß** die H-förmige Leiterstruktur Hohlleiter und/oder Koaxialleiter umfaßt.

20. Vorrichtung nach einem der Ansprüche 1 bis 19, **dadurch gekennzeichnet, daß** die Beschichtungskammern (10, 10') getrennt zueinander angeordnet, insbesondere zueinander abgeschirmt sind.

21. Vorrichtung nach einem der Ansprüche 1 bis 20, **dadurch gekennzeichnet, daß** in jeder der Beschichtungskammern (10, 10') jeweils ein zu beschichtender Gegenstand aufnehmbar ist oder wobei jeweils eine Beschichtungskammer (10, 10') von einem Gegenstand gebildet wird.

22. Vorrichtung nach einem der Ansprüche 1 bis 21, **dadurch gekennzeichnet, daß** den einzelnen Beschichtungskammern getrennte Vakuum- und Gasversorgungseinrichtungen zugeordnet sind.

23. Vorrichtung nach einem der Ansprüche 1 bis 22, **dadurch gekennzeichnet, daß** den einzelnen Beschichtungskammern getrennte Detektionseinheiten zum Erfassen thermischer und/oder elektromagnetischer Emission, ausgehend vom Plasma oder dem zu beschichtenden Substrat, zugeordnet sind.

24. Vorrichtung nach einem der Ansprüche 1 bis 23, **dadurch gekennzeichnet, daß** eine gepulste oder ungepulste zeitlich modulierte Energieversorgung, insbesondere eine gepulste Mikrowellenquelle vorgesehen ist.

25. Vorrichtung nach einem der Ansprüche 1 bis 24, **dadurch gekennzeichnet, daß** die Impedanzstruktur oder Hohlleiterstruktur starre Leiter umfaßt.

**Claims**

1. A device for coating objects, comprising
   a single microwave source and
   two or more separate coating chambers (10, 10'),

all the coating chambers (10, 10') being connected to the single microwave source, and

an impedance structure or a waveguide structure is provided for dividing the microwave energy in order to generate separate plasmas in the individual coating chambers (10, 10').

**2.** A device according to claim 1, **characterised in that** the waveguide structure itself comprises at least one component for dividing the microwave energy.

**3.** A device according to claim 2, **characterised in that** the component for dividing the microwave energy is a y-divider.

**4.** A device according to any of claims 1 to 3, **characterised in that** the waveguide structure comprises a rectangular waveguide.

**5.** A device according to any of claims 1 to 3, **characterised in that** the waveguide structure comprises circular waveguides.

**6.** A device according to any of claims 1 to 5, **characterised in that** the waveguide structure comprises dielectric windows (8, 8', 120, 122) or coaxial conductor structures (A, B, 110) for coupling the microwave energy into each coating chamber.

**7.** A device according to claim 1, **characterised in that** the impedance structure itself comprises at least one component for dividing the microwave energy.

**8.** A device according to claim 7, **characterised in that** in order to couple the microwave energy into the individual coating chambers (10, 10'), the impedance structure comprises a coaxial conductor structure for each chamber, comprising a metal inner conductor (A) and a dielectric outer conductor (B).

**9.** A device according to claim 8, **characterised in that** the means (5, 5'; 6, 6') are provided for altering the electric length of the inner conductors (A).

**10.** A device according to claim 8 or 9, **characterised in that** the coaxial conductor structure comprises a first portion (2) which makes a connection between the microwave source and a branch point.

**11.** A device according to any of claims 1 to 10, **characterised by** the following features:

at least two processing chambers (10, 10') are disposed downstream of an H-shaped conductor structure comprising a web (3) and two limbs (4, 4');

the web (3) is connected to the microwave source by an input conductor (2) and each limb (4, 4') of the H-shaped conductor structure comprises a portion (4.1, 4.1') remote from the respective processing chamber (10, 10') and a portion (4.2, 4.2') facing one of the processing chambers.

**12.** A device according to claim 11, wherein the electric length of the limb portion remote from the relevant processing chamber (10, 10') is adjustable.

**13.** A device according to claim 12, **characterised in that** the electric length of the input conductor portion (2) is also adjustable.

**14.** A device according to claim 12 or 13, **characterised in that** the means for adjusting the electric length comprise a movable jacket (5, 5') surrounding the inner conductor (A).

**15.** A device according to any of claims 11 to 14, **characterised in that** the means for adjusting the electric length of the inner conductor (A) comprise a screw (6, 6') screwable into the inner conductor (A).

**16.** A device according to any of claims 11 to 14, **characterised in that** the web (3) is connected to an additional limb (7).

**17.** A device according to claim 16, **characterised in that** the additional limb (7) is connected to the web (3) substantially in the middle of the web (3) between the two limbs (4, 4').

**18.** A device according to claim 16 or 17, **characterised in that** the electric length of the additional limb (7) is also adjustable.

**19.** A device according to any of claims 11 to 18, **characterised in that** the H-shaped conductor structure comprises waveguides and/or coaxial conductors.

**20.** A device according to any of claims 1 to 19, **characterised in that** the coating chambers (10, 10') are separate, more particularly screened, from one another.

**21.** A device according to any of claims 1 to 20, **characterised in that** each of the coating chambers (10, 10') can hold an object for coating or each coating chamber (10, 10') is formed by an object.

**22.** A device according to any of claims 1 to 21, **characterised in that** the individual coating chambers are associated with separate vacuum and gas supply devices.

**23.** A device according to any of claims 1 to 22, **characterised in that** the individual coating chambers are associated with separate detection units for detecting thermal and/or electromagnetic emission from the plasma or from the substrate for coating.

**24.** A device according to any of claims 1 to 23, **characterised in that** a pulsed or non-pulsed energy supply modulated per unit of time, particularly a pulsed microwave source, is provided.

**25.** A device according to any of claims 1 to 24, **characterised in that** the impedance structure or waveguide structure comprises rigid conductors.

**Revendications**

**1.** Dispositif destiné au revêtement d'objets ; comportant :

une seule source de micro-ondes ;
une ou plusieurs chambres de revêtement (10, 10') séparées ;
toutes les chambres de revêtement (10, 10') étant raccordées à la seule source de micro-ondes ; et
il est prévu une structure d'impédance ou une structure de guides d'ondes pour la répartition de l'énergie des micro-ondes dans le but d'engendrer des plasmas séparés dans les différentes chambres de revêtement (10, 10').

**2.** Dispositif selon la revendication 1, **caractérisé en ce que** la structure de guides d'ondes comporte elle-même au moins un composant pour la répartition de l'énergie des micro-ondes.

**3.** Dispositif selon la revendication 2, **caractérisé en ce que** le composant pour la répartition de l'énergie des micro-ondes est un séparateur en y.

**4.** Dispositif selon l'une des revendications 1 à 3, **caractérisé en ce que** la structure de guides d'ondes comporte un guide d'ondes rectangulaire.

**5.** Dispositif selon l'une des revendications 1 à 3, **caractérisé en ce que** la structure de guides d'ondes comporte un guide d'ondes circulaire.

**6.** Dispositif selon l'une des revendications 1 à 5, **caractérisé en ce que** la structure de guides d'ondes comporte des fenêtres diélectriques (8, 8', 120, 122) ou des structures de guides coaxiaux (A, B, 110) pour le couplage de l'énergie des micro-ondes dans la chambre de revêtement respective.

**7.** Dispositif selon la revendication 1, **caractérisé en ce que** la structure d'impédance comporte elle-même au moins un composant pour la répartition de l'énergie des micro-ondes.

**8.** Dispositif selon la revendication 7, **caractérisé en ce que**, pour le couplage de l'énergie des micro-ondes dans la chambre de revêtement individuelle (10, 10'), la structure d'impédance comporte une structure de guides coaxiaux, comprenant un guide intérieur métallique (A) et un diélectrique (B) en tant que guide extérieur.

**9.** Dispositif selon la revendication 8, **caractérisé en ce que** des moyens (5, 5' ; 6, 6') sont prévus pour modifier la longueur électrique des guides intérieurs (A).

**10.** Dispositif selon la revendication 8 ou 9, **caractérisé en ce que** la structure de guides coaxiaux comporte un premier tronçon de guide (2), qui établit une liaison entre la source de micro-ondes et un point d'embranchement.

**11.** Dispositif selon l'une des revendications 1 à 10, **caractérisé par** les particularités suivantes :

une structure de guides en forme de H, comportant une entretoise (3) ainsi que deux branches (4, 4'), est placée en amont d'au moins deux chambres de traitement (10, 10') ;
l'entretoise (3) est raccordée à la source de micro-ondes par l'intermédiaire d'un guide d'entrée (2) ;
chaque branche (4, 4') de la structure de guides en forme de H comporte un tronçon (4.1, 4.1') qui est opposé à la chambre de traitement (10, 10') concernée, ainsi qu'un tronçon (4.2, 4.2') qui est orienté vers l'une des chambres de traitement (10, 10').

**12.** Dispositif selon la revendication 11, avec lequel la longueur électrique du tronçon de branche opposé à la chambre de traitement (10, 10') respective est réglable.

**13.** Dispositif selon la revendication 12, **caractérisé en ce que** la longueur électrique du tronçon de guide d'entrée (2) est également réglable.

**14.** Dispositif selon la revendication 12 ou 13, **caractérisé en ce que** les moyens destinés au réglage de la longueur électrique sont constitués d'une douille (5, 5') pouvant être déplacée, qui entoure le guide intérieur (A).

**15.** Dispositif selon l'une des revendications 11 à 14, **caractérisé en ce que** les moyens destinés au réglage de la longueur électrique du guide intérieur (A) sont constitués d'une vis (6, 6') pouvant être vissée dans le guide intérieur (A).

16. Dispositif selon l'une des revendications 11 à 14, **caractérisé en ce que** l'entretoise (3) est reliée à une autre branche (7).

17. Dispositif selon la revendication 16, **caractérisé en ce que** l'autre branche (7) est reliée à l'entretoise (3) sensiblement au milieu de l'entretoise (3) entre les deux branches (4, 4').

18. Dispositif selon la revendication 16 ou 17, **caractérisé en ce que** la longueur électrique de l'autre branche (7) est également réglable.

19. Dispositif selon l'une des revendications 11 à 18, **caractérisé en ce que** la structure de guides en forme de H comporte des guides d'ondes et/ou des guides coaxiaux.

20. Dispositif selon l'une des revendications 1 à 19, **caractérisé en ce que** les chambres de revêtement (10, 10') sont disposées séparément l'une de l'autre, notamment blindées l'une par rapport à l'autre.

21. Dispositif selon l'une des revendications 1 à 20, **caractérisé en ce qu'**un objet à revêtir peut être réceptionné respectivement dans chacune des chambres de revêtement (10, 10'), ou **en ce qu'**une chambre de revêtement (10, 10') est respectivement formée par un objet.

22. Dispositif selon l'une des revendications 1 à 21, **caractérisé en ce que** des dispositifs séparés de mise sous vide et d'alimentation en gaz sont associés aux différentes chambres de revêtement.

23. Dispositif selon l'une des revendications 1 à 22, **caractérisé en ce que** des unités de détection séparées sont associées aux différentes chambres de revêtement pour la détection d'émissions thermiques et/ou électromagnétiques émanant du plasma ou du substrat à revêtir.

24. Dispositif selon l'une des revendications 1 à 23, **caractérisé en ce qu'**il est prévu une alimentation en énergie en mode pulsé ou non pulsé modulé dans le temps, notamment une source de micro-ondes en mode pulsé.

25. Dispositif selon l'une des revendications 1 à 24, **caractérisé en ce que** la structure d'impédance ou la structure de guides d'ondes comporte des guides rigides.

Fig. 1

Fig. 2

Fig. 3A

EP 1 415 321 B1

Fig. 3B

14

Fig. 3C

Fig. 3D

## Fig. 4A

100    102    104    108
106    108

## Fig. 4B

104    108    110    114
118    116    112

## Fig. 5

100    102    104    112.2
120    122    112.2

Fig. 6

200.1

200.2  200.3

200.4  200.7

200.5  200.6

112,1  112,2  112,3  112,4

300.1  Fig. 7

302.1  302.2  302.3

304.1  304.2

304.1  304.2  304.1  304.2

112,1  112,2  112,1  112,2  112,1  112,2